Europäisches Patentamt

European Patent Office

Office européen des brevets

(11) Publication number: **0 215 489 B1**

# EUROPEAN PATENT SPECIFICATION

(45) Date of publication of patent specification: **26.02.92**   (51) Int. Cl.⁵: **H01L 29/74**

(21) Application number: **86112950.0**

(22) Date of filing: **19.09.86**

(54) **A shorted anode type gate turn-off thyristor and a process of manufacturing thyristors of this type.**

(30) Priority: **20.09.85 JP 209408/85**

(43) Date of publication of application:
**25.03.87 Bulletin  87/13**

(45) Publication of the grant of the patent:
**26.02.92 Bulletin  92/09**

(84) Designated Contracting States:
**DE FR IT**

(56) References cited:
**EP-A- 0 009 367**
**EP-A- 0 022 355**
**EP-A- 0 160 525**

**PATENT ABSTRACTS OF JAPAN, vol. 8, no.
81 (E-238)(1518), 13 April 1984; & JP-
A-54003969**

**IEEE TRANSACTIONS ON ELECTRON DE-
VICES, vol. ED-28, no. 3, March 1981, pages
270-274, New York, M. AZUM et al.: "2500V
600A gate turn-off Thyristor (GTO)"**

(73) Proprietor: **MITSUBISHI DENKI KABUSHIKI
KAISHA
2-3, Marunouchi 2-chome Chiyoda-ku
Tokyo 100(JP)**

(72) Inventor: **Suzuki, Masanori c/o Kitaitami
Seisakusho
Mitsubishi Denki K.K. 1, Mizuhara 4-chome
Itami-City Hyogo Prefectur(JP)**
Inventor: **Nakagawa, Tsutomu c/o Kitaitami
Seisakusho
Mitsubishi Denki K.K. 1, Mizuhara 4-chome
Itami-City Hyogo Prefectur(JP)**

(74) Representative: **Sajda, Wolf E., Dipl.-Phys. et
al
MEISSNER, BOLTE & PARTNER Widenmayer-
strasse 48 Postfach 86 06 24
W-8000 München 86(DE)**

## Description

This invention relates to a shorted anode type gate turn-off thyristor and to a process of manufacturing a shorted anode type gate turn-off thyristor having an increased controllable anode current.

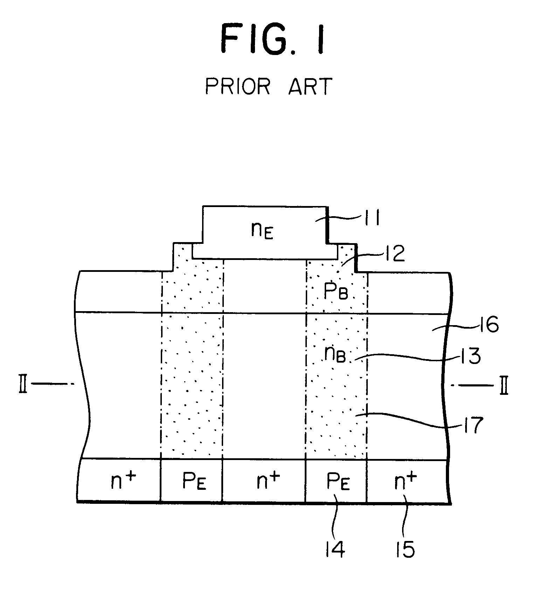

Fig. 1 is a sectional view showing a conventional, shorted anode type gate turn-off thyristor, in which numeral 11 designates an n-type emitter region (hereinbelow, termed "$n_E$ layer"), numeral 12 a p-type base region (hereinbelow, termed "$p_B$ layer"), numeral 13 an n-type base region (hereinbelow, termed "$n_B$ layer"), numeral 14 a p-type emitter region (hereinbelow, termed "$p_E$ layer"),and numeral 15 an n-type region that is a shorted anode portion (hereinbelow, termed "$n^+$ layer").

In the shorted anode type gate turn-off thyristor having such a structure, the $n^+$ layer 15 of the shorted anode portion is effective to draw out excess carriers stored within a wafer at the time of turn-off. The turn-off process proceeds especially from the edge of the $n_E$ layer 11, and an ON region in which the excess carriers are stored is narrowed down to the central position of the $n_E$ layer 11. The $n^+$ layer 15 is therefor disposed in that part of the anode side portion confronting the $n_E$ layer 11, to raise the effect of drawing out the excess carriers. Thus, the shorted anode type gate turn-off thyristor is improved with respect to its turn-off characteristics as compared with a reverse blocking type gate turn-off thyristor which does not have the shorted portion.

Meanwhile, when such a shorted anode type gate turn-off thyristor is to have a higher breakdown voltage, the $n_B$ layer 13 is made thicker. In this case, it is insufficient for the turn-off characteristics to resort only to the carrier drawing-out effect that is the $n^+$ layer 15 of the shorted portion. For this reason, Au, Pt etc., to function as lifetime killer sources are diffused in the $p_B$ layer 12 and the $n_B$ layer 13 so as to recombine the excess carriers.

In the shorted anode type gate turn-off thyristor as described above (and as known from EP-A-0 160 525 falling under Article 54 (3) EPC), the $n_B$ layer 13 is thickened to increase the breakdown voltage, and the lifetime killer sources are diffused for the purpose of enhancing the turn-off characteristics. However, when the impurity concentration of the $n^+$ layer 15 is high (for example, at least $10^{21}$ atoms/cm³) on this occasion, the lifetime killer sources cannot sufficiently be diffused on account of the gettering action of the $n^+$ layer 15, at the step of diffusing them.

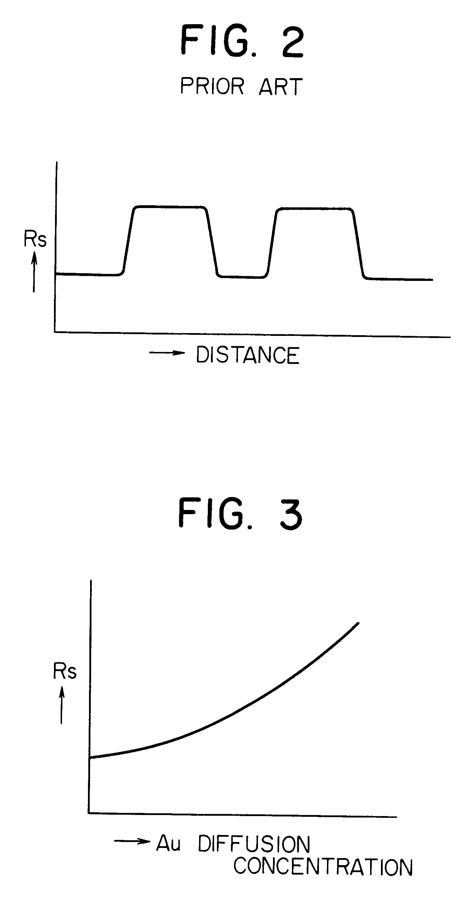

Fig. 2 illustrates a spreading resistance $R_s$ along a line II-II in Fig. 1 in the $n_B$ layer 13 in the case where the impurity concentration of the $n^+$ layer 15 is $10^{21}$ atoms/cm³ and where Au is diffused as the lifetime killer sources. Since Au functions as an acceptor in silicon, it cancels out a donor in the $n_B$ layer 13 and raises the spreading resistance $R_s$ of the $n_B$ layer 13. The relationship between the Au diffusion concentration and the spreading resistance $R_s$ is as shown in a graph of Fig. 3.

More specifically, the spreading resistance $R_s$ is high in a region 17 in which the lifetime killer sources are sufficiently diffused, whereas it is low in a region 16 in which the lifetime killer sources are not diffused considerably because of the gettering action of the $n^+$ layer 15. In the region 16, accordingly, the diffusion concentration of Au to function as the lifetime killer sources is lower than in the region 17, so that the lifetime is not shortened, and the recombination of the excess carriers is unsatisfactory. This effect has led to the problems that the turn-off characteristics are inferior and that the controllable anode current cannot be made large.

This invention has been made in order to solve such problems, and has for its object to provide shorted anode type gate turn-off thyristors and a process of manufacturing shorted anode type gate turn-off thyristors according to which lifetime killer sources are sufficiently diffused even in a region adjoining the $n^+$ layer that is a shorted portion, whereby turn-off characteristics are enhanced and also a controllable anode current can be made high.

The inventive shorted anode type gate turn-off thyristor, has an $n^+$ layer as a shorted anode portion with a high impurity concentration of at most $10^{20}$ atoms/cm³ and lifetime killer sources diffused in a base region of the thyristor for enhancing the turn-off characteristics.

Preferably diffused Au or Pt are provided as lifetime killer sources in a p-type base region and/or in an n-type base region of the thyristor.

According to a further aspect of the invention the spreading resistance of the lifetime killer substances within the n-type base region of the thyristor is substantially uniform.

The process according to the invention for manufacturing a shorted anode type gate turn-off thyristor which has an n-type region of high impuritiy concentration in a shorted anode portion, comprises the step of forming the n-type region of high impurity concentration at an impurity concentration of at most $10^{20}$ atoms/cm³, and the step of subsequently diffusing lifetime killer sources.

According to a further aspect of the invention, the process is characterized in that Au or Pt are diffused as lifetime killer sources.

In this invention, the gettering action of an $n^+$ layer during the diffusion of lifetime killer sources can be enfeebled, and the lifetime killer sources are homogeneously diffused within a wafer.

The invention will be explained in detail below with reference to the accompanying drawings, wherein

Fig. 1 is a sectional view showing a conventional, shorted anode type gate turn-off thyristor;

Fig. 2 is a graph showing a spreading resistance in the $n_B$ layer (n-type base region) of a conventional shorted anode type gate turn-off thyristor along a line II-II in Fig. 1;

Fig. 3 is a graph showing the relationship between the spreading resistance and an Au diffusion concentration in the $n_B$ layer in such a conventional thyristor;

Fig. 4 is a sectional view showing a shorted anode type gate turn-off thyristor according to an embodiment of this invention; and

Fig. 5 is a graph showing the spreading resistance in the $n_B$ layer of the shorted anode type gate turn-off thyristor according to the invention along a line I-I in Fig. 4.

The same symbols in the drawings indicate identical or corresponding portions.

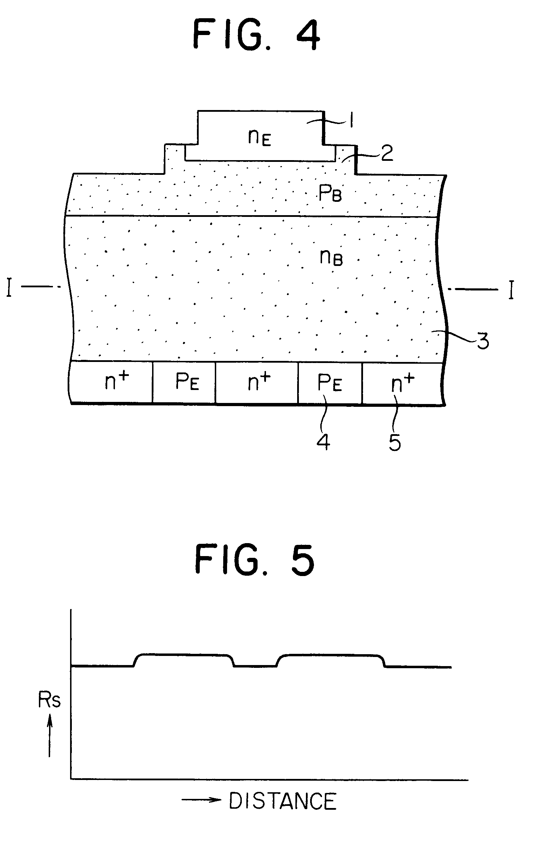

Fig. 4 is a sectional view showing a shorted anode type gate turn-off thyristor produced by an embodiment of a manufacturing process according to this invention. Numeral I designates an n-type emitter region (hereinbelow, termed "$n_E$ layer"), numeral 2 a p-type base region (hereinbelow, termed "$p_B$ layer"), numeral 3 an n-type base region (hereinbelow, termed "$n_B$ layer"), numeral 4 a p-type emitter region (hereinbelow, termed "$p_E$ layer), and numeral 5 an $n^+$ layer that is a shorted anode portion (hereinbelow, termed "$n^+$ layer").

The manufacturing process of the thyristor according to the present invention is similar to that of the prior art, in that lifetime killer sources are diffused after the $n^+$ layer 5 has been formed. However, since the impurity concentration of the $n^+$ layer 5 is made at most $10^{20}$ atoms/cm$^3$ at the step of forming the $n^+$ layer 5, the gettering action of this $n^+$ layer 5 can be considerably weakened. Therefore, the lifetime killer sources can be homogeneously diffused in the $n_B$ layer 3, and the spreading resistance $R_s$ along a line I - I in Fig. 4 within the $n_B$ layer 3 becomes substantially uniform as illustrated in Fig. 5.

In the shorted anode type gate turn-off thyristor thus formed, the lifetime killer sources homogeneously diffused can recombine with excess carriers, so that the lifetime of the carriers can be sufficiently shortened at the time of turn-off, along with the attainment of a very efficient carrier drawing-out effect of the $n^+$ layer 5.

A turn-off test of this shorted anode type gate turn-off thyristor was conducted. As a result, it has been verified that the thyristor has its controllable anode current raised by about 200 A - 300 A as compared with a conventional example.

As described above, this invention comprises the step of forming an n + layer that is a shorted anode portion whose impurity concentration is at most $10^{20}$ atoms/cm$^3$, before the step of diffusing lifetime killer sources. Therefore, when the lifetime killer sources are diffused, they can be homogeneously diffused in a wafer without being gettered by the $n^+$ layer, to bring forth the effect that the controllable anode current can be increased.

**Claims**

1.  A shorted anode type gate turn-off thyristor, having an $n^+$ layer (5) as a shorted anode portion with a high impurity concentration of at most $10^{20}$ atoms/cm$^3$, and lifetime killer sources diffused in a base region (2, 3) of the thyristor for enhancing the turn-off characteristics.

2.  The thyristor according to claim I, characterized in that diffused Au or Pt are provided as lifetime killer sources in a p-type base region (2) and/or an n-type base region (3) of the thyristor.

3.  The thyristor according to claim I or 2, characterized in that the spreading resistance (Rs) of the lifetime killer sources within the n-type base region (3) is substantially uniform.

4.  A process for manufacturing a shorted anode type gate turn-off thyristor which has an n-type region of high impurity concentration in a shorted anode portion, comprising the step of forming said n-type region of high impurity concentration at an impurity concentration of at most $10^{20}$ atoms/cm$^3$, and the step of subsequently diffusing lifetime killer sources.

5.  The process according to claim 4, characterized in that Au or Pt are diffused as lifetime killer sources.

**Revendications**

1.  Thyristore à anode court-circuitée du type à blocage par la gachette, ayant une couche $n^+$ - (5) comme portion d'anode court-circuitée avec une concentration d'impuretés élevée d'au moins $10^{20}$ atomes/cm$^3$, et des sources de réduction de durée de vie diffusées dans une région de base (2, 3) du thyristore pour améliorer ses caractéristiques de blocage.

2.  Thyristore selon la revendication 1, caractérisé en ce que du Au du Pt diffusés sont prévus comme source de réduction de durée de vie dans une région de base du type p (2) et/ou dans une région de base du type n (3) du thyristore.

3.  Thyristore selon la revendication 1 ou 2, caractérisé en ce que la résistance à la diffusion (Rs) des sources de réduction de durée de vie à l'intérieur de la région de base du type n (3) est substantiellement uniforme.

4.  Procédé de fabrication d'un thyristore à anode court-circuité du type à blocage par gachette qui possède une région de type n à concentration d'impuretés élevée dans une portion d'anode court-circuitée, comprenant l'étape consistant à former ladite région de type n à concentration d'impuretés élevée avec une concentration d'impuretés d'au moins $10^{20}$ atomes/cm$^3$, et l'étape suivante consistant à ensuite diffuser les sources de réduction de durée de vie.

5.  Procédé selon la revendication 4, caractérisé en ce que du Au du Pt sont diffusés en tant que source de réduction de vie.

**Patentansprüche**

1.  Abschaltthyristor mit kurzgeschlossener Anode, der folgendes aufweist:
    eine n$^+$-Schicht (5) als kurzgeschlossenen Anodenbereich mit einer hohen Verunreinigungskonzentration von höchstens $10^{20}$ Atome/cm$^3$, und Lebensdauer-Verkürzungsmittel, die in einen Basisbereich (2, 3) des Thyristors eindiffundiert sind, um die Abschaltcharakteristik zu verbessern.

2.  Thyristor nach Anspruch 1,
    dadurch gekennzeichnet,
    daß eindiffundiertes Au oder Pt als Lebensdauer-Verkürzungsmittel in einem p-Typ Basisbereich (2) und/oder einem n-Typ Basisbereich (3) des Thyristors vorgesehen sind.

3.  Thyristor nach Anspruch 1 oder 2,
    dadurch gekennzeichnet,
    daß der Ausbreitungswiderstand (Rs) der Lebensdauer-Verkürzungsmittel innerhalb des n-Typ Basisbereiches (3) im wesentlichen gleichmäßig ist.

4.  Verfahren zur Herstellung eines Abschaltthyristors mit kurzgeschlossener Anode, der einen n-Typ Bereich mit hoher Verunreinigungskonzentration in einem kurzgeschlossenen Anodenbereich aufweist,

umfassend den Schritt der Herstellung des n-Typ Bereiches hoher Verunreinigungskonzentration mit einer Verunreinigungskonzentration von höchstens $10^{20}$ Atome/cm$^3$, und den Schritt des anschließenden Eindiffundierens von Lebensdauer-Verkürzungsmitteln.

5.  Verfahren nach Anspruch 4,
    dadurch gekennzeichnet,
    daß Au oder Pt als Lebensdauer-Verkürzungsmittel eindiffundiert werden.

# FIG. I

## PRIOR ART

# FIG. 2

PRIOR ART

Rs →

→ DISTANCE

# FIG. 3

Rs →

→ Au DIFFUSION
CONCENTRATION

# FIG. 4

# FIG. 5